# EUROPEAN PATENT APPLICATION

(11) **EP 4 835 961 A1**
(43) Date of publication of application: **04.11.2026**
(21) Application number: 24919715.3
(22) Date of filing: 30.08.2024
(51) Int. Cl.: H01L 23/538

(54) **INTERCONNECTION INTERPOSER COMPONENT, CHIP PACKAGING SYSTEM, AND ELECTRONIC DEVICE**

(30) Priority: 24.01.2024 CN 202410101900
(71) Applicant: Huawei Technologies Co., Ltd., Shenzhen, Guangdong 518129 (CN)
(72) Inventor: GAO, Feng, Shenzhen, Guangdong 518129 (CN); YU, Meina, Shenzhen, Guangdong 518129 (CN); YU, Chaowei, Shenzhen, Guangdong 518129 (CN); HAN, Jianhua, Shenzhen, Guangdong 518129 (CN); XIE, Ertang, Shenzhen, Guangdong 518129 (CN); CHENG, Hua Wei, Shenzhen, Guangdong 518129 (CN)
(74) Representative: Huawei European IPR
(86) International application number: PCT/CN2024/115785
(87) International publication number: WO 2025/156634

(57) **Abstract**

An interconnection interposer component, a chip packaging system, and an electronic device are provided. The interconnection interposer component includes a local interconnection component and a carrier layer. The local interconnection component is embedded in the carrier layer. A first through via in the carrier layer runs through a first surface and a second surface of the carrier layer, and a second through via in the carrier layer runs through a slot bottom of a first slot and the second surface of the carrier layer. A build-up layer on a first surface side of the carrier layer is provided with a first interface and a second interface that are configured to connect to dies, and a build-up layer on a second surface side of the carrier layer is provided with a third interface and a fourth interface that are configured to connect to a PCB. The first interface is electrically connected to the third interface through the first through via, the second interface is electrically connected to the fourth interface through the local interconnection component and the second through via, and the local interconnection component is electrically connected to a plurality of second interfaces. In this way, a high-density layout requirement is met, and mountability, reliability, and availability of the system are effectively improved.

## Description

This application claims priority to Chinese Patent Application No. 202410101900.9, filed with the China National Intellectual Property Administration on January 24, 2024 and entitled "INTERCONNECTION INTERPOSER COMPONENT, CHIP PACKAGING SYSTEM, AND ELECTRONIC DEVICE", which is incorporated herein by reference in its entirety.

### TECHNICAL FIELD

Embodiments of this application relate to the field of chip packaging technologies, and in particular, to an interconnection interposer component, a chip packaging system, and an electronic device.

### BACKGROUND

With increasing difficulty in transistor scaling and increasing requirements for high performance of chips, the industry has begun to explore solutions in the packaging field. In a conventional chip-on-board system, dies (dies) are packaged on a substrate to form a chip package, and then the chip package is mounted on a PCB (printed circuit board, printed circuit board). FCBGA (Flip chip BGA, flip chip ball grid array packaging) technology has been widely applied due to its advantages, such as high integration, high performance, and low power consumption.

To meet high-density layout requirements, in a typical FCBGA packaging architecture, a silicon interposer (interposer) based on an RDL (re-distributed layer, re-distributed layer) is disposed between the dies and the substrate, so that the dies are placed at a small pitch, and bandwidth performance is effectively improved. As more chips are integrated, the size of the FCBGA becomes increasingly large, leading to development bottlenecks in aspects of mountability, reliability, and availability.

### SUMMARY

Embodiments of this application provide an interconnection interposer component, a chip packaging system, and an electronic device, so that a high-density layout requirement is met, and mountability, reliability, and availability of the system are effectively improved.

A first aspect of embodiments of this application provides an interconnection interposer component. The interconnection interposer component includes a local interconnection component and a carrier layer. The carrier layer of the interconnection interposer component includes a first surface and a second surface. The first surface of the carrier layer is provided with a first slot, and the local interconnection component is embedded in the first slot. The carrier layer is provided with a first through via and a second through via. The first through via runs through the first surface and the second surface of the carrier layer, and the second through via runs through a slot bottom of the first slot and the second surface of the carrier layer. Two sides of the carrier layer each are covered with a build-up layer. That is, a first surface side of the carrier layer is covered with a first build-up layer, and a second surface side of the carrier layer is covered with a second build-up layer. The build-up layer on the first surface side of the carrier layer is provided with a first interface and a second interface that are configured to connect to dies, and the build-up layer on the second surface side of the carrier layer is provided with a third interface and a fourth interface that are configured to connect to a printed circuit board. The first interface is electrically connected to the third interface through the first through via, the second interface is electrically connected to the fourth interface through the local interconnection component and the second through via, and the local interconnection component is electrically connected to a plurality of second interfaces.

Based on the local interconnection component of the interconnection interposer component, high-density connection between dies during packaging on the board can be implemented. In addition, an individual size of the product is small, which can effectively reduce a deformation risk and offer high reliability. In addition, this can reduce difficulty of an assembly process, offer good mountability, and effectively improve a product manufacturing yield rate.

In addition, the interconnection interposer component is formed based on the carrier layer, and may be constructed and configured based on a quantity of to-be-interconnected dies, so that an individual size of the interconnection interposer component can be properly controlled. During actual application, the interconnection interposer component is not affected by difficulty in implementing a large-size substrate, which offers good availability. In addition, the interconnection interposer component with a small individual size offers good assembly processability, and actually occupies a small board size, so that more devices can be disposed, and availability can be further improved.

During actual application, the carrier layer may be made of a rigid inorganic material, and is used as an arrangement carrier of the local interconnection component, so that the interconnection interposer component has high flatness. Based on good individual flatness, difficulty of the assembly process can be further reduced, and mountability can be improved.

For example, the rigid inorganic material may be a glass material, to ensure mechanical stability of the interconnection interposer component, and effectively avoid impact of excessively large deformation of the carrier on interconnection reliability. In addition, the glass material has a low permittivity, and a loss and parasitic effect can be effectively controlled, so that high-density connection is implemented, and integrity of a transmitted signal can be ensured.

Based on the first aspect, this embodiment of this application further provides a first implementation of the first aspect: The first through via and the second through via in the carrier layer are TGVs (through glass vias, through glass vias). In this way, each blind via located in the first build-up layer can communicate with a blind via located in the second build-up layer through the through via in the carrier layer, to implement electrical connection between the die and the PCB. Based on good via distribution density and a good via filling capability of the TGV, a heat transfer capability and a through-current capability from one side to the other side of the interconnection interposer component can be further improved, which provides technical assurance for ensuring performance of a chip in a high-density layout.

Based on the first aspect or the first implementation of the first aspect, this embodiment of this application further provides a second implementation of the first aspect: The build-up layer is made of an organic material. In other words, the build-up layers on the two sides of the carrier layer are both made of the organic material, and the local interconnection component used for a high-density layout of the dies is manufactured by using the rigid inorganic carrier and an organic build-up layer system.

For example, the build-up layer may be made of an ABF (Ajinomoto Build-up Film, Ajinomoto build-up film). This can ensure a via shape and size precision of the blind via in the build-up layer, to facilitate formation of reliable electrical connection.

During actual application, the build-up layer may alternatively be made of another organic material such as a PP (prepreg, prepreg).

Based on the first implementation of the first aspect, this embodiment of this application further provides a second implementation of the first aspect: The first interface, the second interface, the third interface, and the fourth interface are respectively interface pads formed on the build-up layers on the sides on which the first interface, the second interface, the third interface, and the fourth interface are located. In other words, a first interface pad and a second interface pad that are configured to connect to the dies are formed on the first build-up layer. The first interface pad is electrically connected to the first through via, and the second interface pad is electrically connected to a top pin of the local interconnection component. A third interface pad and a fourth interface pad that are configured to connect to the PCB are formed on the second build-up layer. The third interface pad is electrically connected to the first through via, and the fourth interface pad is electrically connected to the second through via. In this way, as interfaces connected to the dies and the PCB, the interface pads can be directly configured to implement corresponding electrical connection, and are characterized by a simple structure and good processability.

Based on the second implementation of the first aspect, an embodiment of this application further provides a third implementation of the first aspect: The build-up layers on the two sides of the carrier layer each are covered with a solder mask layer. A first external connection bump and a second external connection bump are formed on a solder mask layer on one side of the carrier layer, and the first external connection bump and the second external connection bump are respectively electrically connected to the first interface and the second interface on the side on which the first external connection bump and the second external connection bump are located. A third external connection bump and a fourth external connection bump are formed on a solder mask layer located on the other side of the carrier layer, and the third external connection bump and the fourth external connection bump are respectively electrically connected to the third interface and the fourth interface on the side on which the third external connection bump and the fourth external connection bump are located. In this way, the external connection bumps (bumps) are stacked on the interface pads, to implement connection to the dies and the PCB through corresponding external connection bumps. This offers good assembly processability.

Based on the third implementation of the first aspect, this embodiment of this application further provides a fourth implementation of the first aspect: The second external connection bump is of a nickel/tin pillar (Ni/Sn Pillar) structure, where second external connection bumps may be, for example but not limited to, nickel/tin pillars at a pitch of 50 um. In this way, a high-density bump layout can be formed in correspondence to a high-density interconnection line layer on a local interconnection component-2 side, and reliable electrical connection and good heat dissipation performance can be provided.

Based on the first aspect, or the first implementation of the first aspect, or the second implementation of the first aspect, or the third implementation of the first aspect, or the fourth implementation of the first aspect, an embodiment of this application further provides a fifth implementation of the first aspect: The interconnection interposer component further includes a passive device. Correspondingly, the first surface of the carrier layer is further provided with a second slot, and the passive device is embedded in the second slot. The build-up layer on the first surface side of the carrier layer is further provided with a fifth interface configured to connect to a die, and the fifth interface is electrically connected to a top pin of the passive device. During actual application, the passive device may be embedded on the first surface side of the carrier layer according to an actual requirement, so that electrical performance can be further improved without increasing a board area occupied by the interconnection interposer component.

For example, the passive device may be a device such as a capacitor, a resistor, or an inductor.

During actual application, a fifth external connection bump may be further formed on the solder mask layer located on the one side of the carrier layer, and the fifth external connection bump is electrically connected to the fifth interface. In this way, connection to a die side can be implemented through a corresponding external connection bump. This offers good assembly processability.

During other actual application, the first external connection bump, the third external connection bump, the fourth external connection bump, and the fifth external connection bump are all of external bump structures formed by using a small outline package (Small Outline Package, SOP) process, where first external connection bumps, third external connection bumps, fourth external connection bumps, or fifth external connection bumps are, for example but not limited to, external bump structures at a pitch of 130 um to 150 um. This offers good processability.

Based on the first aspect, or the first implementation of the first aspect, or the second implementation of the first aspect, or the third implementation of the first aspect, or the fourth implementation of the first aspect, or the fifth implementation of the first aspect, this embodiment of this application further provides a sixth implementation of the first aspect: The local interconnection component includes a dielectric layer and the high-density interconnection line layer that are stacked, and the dielectric layer is made of an organic material. For example, the dielectric layer of the local interconnection component 2 may be made of PI (polyimide, polyimide), PP (polypropylene, polypropylene), or an ABF (Ajinomoto Build-up Film, Ajinomoto build-up film dielectric material).

A second aspect of embodiments of this application provides a chip packaging system. The chip packaging system includes a PCB, a plurality of dies, and the foregoing interconnection interposer component. The interconnection interposer component is disposed on a board surface of the PCB and is connected to the PCB through the third interface and the fourth interface, at least two dies are coupled to the PCB through the interconnection interposer component and are connected to the interconnection interposer component through the first interface and the second interface, and two adjacent dies are electrically connected through the local interconnection component on the interconnection interposer component. In this way, high-density short-distance electrical connection between the dies and between the dies and the PCB can be implemented by using the interconnection interposer component, where the electrical connection can be respectively used to implement, for example but not limited to, power supply, communication (data signal and control signal) transmission, and the like. In addition, based on the interconnection interposer component with good reliability, good mountability, and good availability, a design requirement on a PCB side can be reduced, and design costs and process implementation costs of a board-level packaging system can be properly controlled.

During actual application, a quantity of disposed interconnection interposer components may be determined according to an actual system function requirement, and the interconnection interposer components may be spaced apart.

For example, a substrate of the PCB may be a BT board, a ceramic board, a glass board, or a metal board.

Based on the second aspect, this embodiment of this application further provides a first implementation of the second aspect: At least one die is electrically connected to the passive device on the interconnection interposer component through the fifth interface. In this way, a trend requirement of a high-density layout is met, while good electrical performance is delivered.

Based on the second aspect or the first implementation of the second aspect, this embodiment of this application further provides a second implementation of the second aspect: A solder joint between the interconnection interposer component and the PCB is covered with underfill, to effectively improve soldering reliability.

For example, after a flux cleaning operation is performed, an underfill process may be used to protect the solder joint between the interconnection interposer component and the PCB, and then the dies are assembled.

Based on the second aspect, or the first implementation of the second aspect, or the second implementation of the second aspect, this embodiment of this application further provides a third implementation of the second aspect: The chip packaging system further includes another functional device disposed on the PCB. During actual application, the another functional device disposed on the PCB may include at least one of a power supply assembly, a connector, and a capacitor.

For example, for the power supply assembly, the dies and the interconnection interposer component are located on the board surface on one side of the PCB, and the power supply assembly is located on a board surface on the other side of the PCB, that is, located on a board surface of the PCB on a side opposite to the dies, so that a board-level architecture with vertical power supply is formed, characterized by a low power supply loss and high integration. For another example, the power supply assembly, the dies, and the interconnection interposer component may alternatively be located on the board surface on the same side of the PCB, to form a board-level architecture with horizontal power supply.

For still another example, for the connector, the connector, the dies, and the interconnection interposer component may be located on the board surface on the same side, so that a link length is properly controlled, and a link loss between the connector and the dies can be reduced.

A third aspect of embodiments of this application provides an electronic device. The electronic device includes a mainboard and the foregoing chip packaging system, and the chip packaging system is disposed on the mainboard. For example, the chip packaging system may be a functional component such as a CPU (Central Processing Unit, central processing unit), a GPU (Graphic Processing Unit, graphic processing unit), an ASIC (Application-Specific Integrated Circuit, application-specific integrated circuit), or a SOC (System on Chip, system on chip) that is configured in the electronic device.

During actual application, the electronic device may be a server, a computer, or a high-performance compute cluster. In addition, the electronic device may be a switch, a router, a building baseband unit, an edge device, or the like.

### BRIEF DESCRIPTION OF DRAWINGS

FIG. 1 is a diagram of an architecture of a chip-on-board system according to an embodiment of this application;
FIG. 2 is a diagram of an interconnection interposer component according to an embodiment of this application;
FIG. 3 is a schematic flowchart of assembly of a chip-on-board system according to an embodiment of this application;
FIG. 4 is a diagram of another interconnection interposer component according to an embodiment of this application;
FIG. 5 is a diagram of an architecture of another chip-on-board system according to an embodiment of this application; and

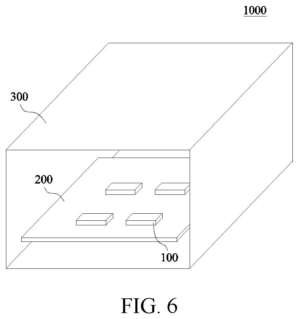

FIG. 6 is a diagram of a structure of an electronic device according to an embodiment of this application.

### DESCRIPTION OF EMBODIMENTS

Embodiments of this application provide an implementation solution of a locally high-density chip packaging structure, to effectively meet a high-density layout requirement on a basis of improving mountability, reliability, and availability.

In high-density layout and high-integration scenarios, flip chips (flip chips) are used in medium- and high-performance products. A typical FCBGA packaging architecture is used as an example. A line width capability of a substrate is usually about 15 um. To improve architecture layout density, a silicon interposer is disposed between a die and the substrate in the architecture. A line width capability of an RDL fabricated on a silicon chip may reach 1 um, which is far less than a line width of an RDL fabricated on a resin substrate, so that dies can be placed at a small pitch. An FCBGA package is mounted on a PCB to form a chip-on-board system that can meet specified functions. With improvement of product performance, a quantity of dies integrated in the FCBGA packaging architecture increases accordingly, and consequently, an FCBGA size increases accordingly, and a development bottleneck occurs in aspects such as mountability, reliability, and availability.

Based on this, an embodiment of this application provides an interconnection interposer component, including a local interconnection component and a carrier layer. The local interconnection component includes a dielectric layer and a high-density interconnection line layer that are stacked. The carrier layer includes a first surface and a second surface. The first surface of the carrier layer is provided with a first slot, and the local interconnection component is embedded in the first slot. The carrier layer is provided with a first through via and a second through via. The first through via runs through the first surface and the second surface of the carrier layer, and the second through via runs through a slot bottom of the first slot and the second surface of the carrier layer. A first surface side of the carrier layer is covered with a first build-up layer, and the first build-up layer is provided with a first interface and a second interface that are configured to connect to dies. The first interface is electrically connected to the first through via, the second interface is electrically connected to the local interconnection component, and the local interconnection component is electrically connected to a plurality of second interfaces. A second surface side of the carrier layer is provided with a second build-up layer, and a third interface and a fourth interface that are configured to connect to a PCB are formed on the second build-up layer, where the third interface is electrically connected to the first through via, and the fourth interface is electrically connected to the second through via.

In this way, based on the interconnection interposer component, high-density connection between dies during packaging on the board can be implemented. The carrier layer is used as an arrangement carrier of the local interconnection component. An individual size is small, which can effectively reduce a deformation risk and offer high reliability. This embodiment of this application is different from an FCBGA packaging architecture in that the interconnection interposer component is used as a connection layer, and interposer→substrate→PCB is simplified to interposer (interconnection interposer component)→PCB, so that dies of different processes can be directly mounted on the PCB, to effectively avoid mounting difficulty caused by warping of a large-sized FCBGA, offer good mountability, and effectively improve a product manufacturing yield.

In addition, the interconnection interposer component formed based on the carrier layer may be constructed based on a quantity of to-be-interconnected dies, so that an individual size is properly controlled. During actual application, the interconnection interposer component is not affected by difficulty in implementing a large-size substrate, which offers good availability. In addition, the interconnection interposer component with a small individual size offers good processability, so that availability can be further improved.

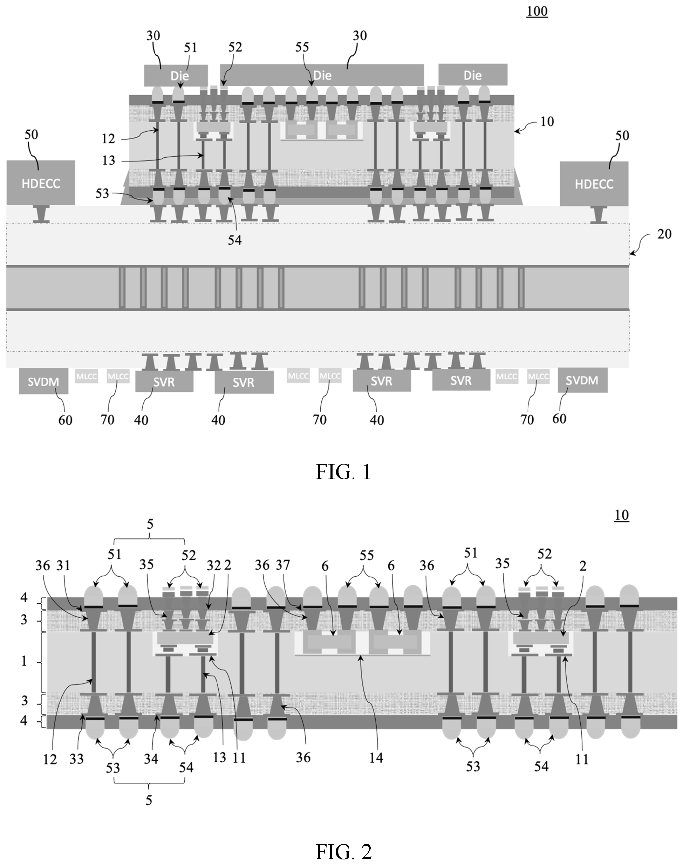

To better understand the technical solutions and technical effects of this application, without loss of generality, the following uses a board-level architecture with vertical power supply as an application example of the interconnection interposer component, and describes specific embodiments in detail with reference to the accompanying drawings. FIG. 1 is a diagram of an architecture of a chip-on-board system according to an embodiment of this application.

As shown in FIG. 1, an interconnection interposer component 10, a power supply assembly 40, and a connector 50 are disposed on a PCB 20 of the chip-on-board system 100. For a plurality of dies 30, high-density short-distance electrical connection between the dies 30 and between the dies 30 and the PCB 20 is implemented by using the interconnection interposer component 10, where the electrical connection can be respectively used to implement, for example but not limited to, power supply, communication (data signal and control signal) transmission, and the like. In this implementation solution, the dies 30 are located on a board surface on one side of the PCB 20, and the power supply assembly 40 is located on a board surface on the other side of the PCB 20, so that a board-level architecture with vertical power supply is formed, characterized by a low power supply loss and high integration. In another possible implementation solution, the power supply assembly 40 and the dies 30 may alternatively be located on the board surface on the same side of the PCB 20, to form a board-level architecture with horizontal power supply.

During specific implementation, the architecture of the chip-on-board system may be implemented by using an mSAP (Modified Semi-Additive Process, modified semi-additive process) process or an SAP (Semi-Additive Process, semi-additive process) process. This is not limited in embodiments of this application.

For example, in this implementation solution, one interconnection interposer component 10 is disposed on a board surface on one side of the PCB 20, the dies 30 may be coupled to the PCB 20 and electrically connected to the PCB 20 through the interconnection interposer component 10. In addition, electrical connection between two adjacent dies 30 is implemented based on the interconnection interposer component 10, where the electrical connection can be used for, for example but not limited to, high-performance data transmission between the dies.

It should be understood that, in another possible implementation solution, a quantity of disposed interconnection interposer components 10 may be determined according to an actual system function requirement. For example, a plurality of interconnection interposer components (not shown in the figure) may be disposed, for example, but not limited to, two interconnection interposer components or three interconnection interposer components. When the plurality of interconnection interposer components are disposed on the board surface on the one side of the PCB 20, the interconnection interposer components may be spaced apart. During specific implementation, no matter how many interconnection interposer components 10 are on the PCB 20, the interconnection interposer components 10 are connected to the PCB and the die 30 in a same manner. Therefore, the following uses an example in which one interconnection interposer component 10 is disposed on the PCB for description.

For the plurality of dies assembled on the board, some dies may implement electrical connection based on the interconnection interposer component, and the other dies may be directly electrically connected to the PCB 20 (not shown in the figure). For the dies that implement electrical connection based on the interconnection interposer component, in an implementation, each die may implement connection between dies based on the local interconnection component 2 on the interconnection interposer component 10. In another implementation, alternatively, some dies may implement connection between dies based on the local interconnection component 2 on the interconnection interposer component 10. In other words, in the dies that implement electrical connection based on the interconnection interposer component, at least two dies 30 are electrically connected through the local interconnection component 2. This may be specifically determined based on an overall product design. This is not limited in embodiments of this application.

The connector 50, the interconnection interposer component 10, and the plurality of dies 30 are located on the board surface on the same side of the PCB 20, and are configured to connect to another external device (not shown in the figure). The connector 50 and the dies 30 are located on the board surface on the same side, so that a link length is properly controlled, and a link loss between the connector and the dies can be reduced. A structure form and a quantity of disposed connectors 50 mounted on the PCB 20 may be configured based on a function of the board-level system, to implement electrical interconnection between the external device and a PCB-20 side, and meet a requirement of electrical interaction.

In addition, as an optional configuration structure, the connector 50 may alternatively be located on the board surface on the other side that is of the PCB 20 and that is opposite to the interconnection interposer component 10 and the dies 30, instead of being limited to being located on the board surface on the same side of the PCB 20 with the interconnection interposer component 10 and the dies 30. This is not limited in embodiments of this application.

As shown in FIG. 1, in addition to the power supply assembly 40 and the connector 50, other functional devices may be further disposed on the PCB 20 of the chip-on-board system 100. Optionally, other board-level functional devices may be further disposed on the PCB 20. As shown in FIG. 1, for the board-level architecture with vertical power supply, a super voltage divider module (Super Voltage Divider Module, SVDM) 60 is disposed on the board surface on the other side of the PCB 20. Based on an SVDM switching technology, an input voltage may be increased to a higher voltage output through a voltage doubling circuit. In addition, a multi-layer ceramic capacitor (Multi-layer Ceramic Capacitor, MLCC) 70 is further disposed on the board surface on the other side of the PCB 20, to improve power supply performance.

In another possible implementation, in addition to the SVDM, other active devices may be further integrated on the PCB 20, for example, but not limited to, a voltage stabilizer configured to ensure stability of an output voltage, a current sensor configured to monitor a current output by a power supply, a voltage sensor configured to monitor a voltage output by the power supply, and the like. In addition to a capacitor, another passive device may be further integrated on the PCB 20, for example, but not limited to, a device such as a resistor or an inductor.

It should be understood that the another functional device on the PCB 20 may be configured based on the function of the board-level system in an actual application scenario. This is not limited in embodiments of this application.

For the architecture of the chip-on-board system, the dies 30 may be dies of a same type, or dies of different types to implement different function configurations. During specific implementation, at least a part of the plurality of dies 30 are memory dies, which may be determined according to an overall design requirement of a specific application scenario, to implement a data read/write operation for, for example but not limited to, integrated circuit components such as a CPU, a GPU, an ASIC, and a SOC. This is not limited in embodiments of this application.

In this implementation solution, a carrier layer 1 of the interconnection interposer component 10 configured to implement high-density short-distance connection between the dies and between the dies and the PCB is made of a rigid inorganic material, to provide stable mechanical performance. The "rigid inorganic material" herein means an inorganic material with high hardness, good rigidity, and high chemical stability, for example, but not limited to, a glass base material. In another possible implementation, the carrier layer 1 may alternatively use another rigid inorganic material to manufacture a carrier base material of a local interconnection device. This is not limited in embodiments of this application.

FIG. 2 is a diagram of an interconnection interposer component according to an embodiment of this application.

In this implementation solution, a carrier layer 1 of the interconnection interposer component 10 is made of a glass material, to ensure mechanical stability of the interconnection interposer component 10, and avoid impact of excessively large deformation of a carrier on interconnection reliability. In addition, the glass material has a low permittivity, and a loss and parasitic effect are effectively controlled, so that high-density connection is implemented, and integrity of a transmitted signal can be ensured.

A local interconnection component 2 is embedded in the carrier layer 1. The local interconnection component 2 includes a dielectric layer and a high-density interconnection line layer that are stacked. A structure of the local interconnection component 2 may be a structure of a mixture of a dielectric and a re-distributed layer. That is, the high-density interconnection line layer is constructed by using the re-distributed layer. For example, the local interconnection component 2 may be a structure formed by alternately stacking a layer of dielectric and a layer of metal (such as copper). However, this is not limited thereto. The local interconnection component 2 may be used to implement electrical connection between two adjacent dies 30, and also implement electrical connection between two adjacent dies 30 in a group of dies.

In addition, a passive device 6 is further embedded in the carrier layer 1. The passive device 6 may be, for example but not limited to, a device such as a capacitor, a resistor, or an inductor, so that electrical performance is improved without increasing a board area occupied by the interconnection interposer component 10 on a PCB. In another possible implementation, according to a chip performance requirement, the passive device 6 may be an optionally configured device. That is, the passive device may not be configured in the carrier layer 1.

Specifically, the carrier layer 1 includes a first surface and a second surface. The first surface of the carrier layer 1 is provided with a first slot 11 and a second slot 14, respectively for embedding the local interconnection component 2 and the passive device 6. The local interconnection component 2 is embedded in the first slot 11, and the passive device 6 is embedded in the second slot 14. It may be understood that "embedded" herein includes a case in which the device is completely embedded in a corresponding embedding slot, and further includes a case in which a small portion of the device is exposed outside the corresponding embedding slot.

In this implementation, the local interconnection component 2 may be of a top-bottom double-sided connection structure. A placement direction of the interconnection interposer component 10 shown in FIG. 2 is used as a reference direction. A pin configured to electrically connect to the die 30 is located at a top of the local interconnection component 2, and a pin configured to electrically connect to the PCB 20 is located at a bottom of the local interconnection component 2. The interconnection interposer component 10 provided in this implementation solution implements, by using a build-up (build-up) layer 3, external electrical connection for the local interconnection component 2 disposed in the carrier layer 1.

During specific implementation, the build-up layer 3 may be made of an organic material, for example, but not limited to, an ABF, to ensure a formed shape and size precision of a blind via in the build-up layer, and facilitate formation of reliable electrical connection. Overall, the local interconnection component 2 is manufactured by using the rigid inorganic carrier and an organic build-up layer system to form the interconnection interposer component 10.

In another specific implementation, the build-up layer 3 may alternatively be made of another organic material such as PP.

As shown in FIG. 2, a build-up layer 3 covered on a first surface side of the carrier layer 1 is a first build-up layer, and a build-up layer 3 covered on a second surface side of the carrier layer 1 is a second build-up layer. Blind vias for external connection are formed on a material of the build-up layer 3, and interface pads for connecting the die to the local interconnection component 2 and the PCB are provided on surfaces of the build-up layers 3. In addition, the interconnection interposer component 10 implements top-bottom interconnection by using through vias provided in the carrier layer 1. During specific implementation, metallization may be performed based on through glass vias TGVs to form TGV through vias for top-bottom interconnection. With reference to FIG. 1, in other words, each blind via located in the first build-up layer directly or indirectly communicates with a blind via located in the second build-up layer through the through via in the carrier layer 1, to implement electrical connection between the die and the PCB. In this way, based on good via distribution density and a good via filling capability of the TGV, heat transfer and through-current capabilities in a Z direction (a direction perpendicular to the carrier layer) can be further improved.

Specifically, the through vias in the carrier layer 1 include a first through via 12 and a second through via 13, where the first through via 12 runs through the first surface and the second surface of the carrier layer 1. In this way, the blind via located in the first build-up layer can be directly connected to the blind via located in the second build-up layer through the through via in the carrier layer 1. With reference to FIG. 1, the die 30 is interconnected with a PCB-20 side through the first through via 12. The second through via 13 runs through a slot bottom of the first slot 11 and the second surface of the carrier layer 1. Based on electrical connection between the bottom pin of the local interconnection component 2 embedded in the first slot 11 and the second through via 13, the blind via located in the first build-up layer may be indirectly connected to the blind via located in the second build-up layer through the through via in the carrier layer 1. As shown in FIG. 1, the die 30 is interconnected with the PCB-20 side through the local interconnection component 2 and the second through via 13.

Correspondingly, a first interface pad 31, a second interface pad 32, and a fifth interface pad 37 that are configured to connect to dies 30 are formed on the first build-up layer. The first interface pad 31 is electrically connected to the first through via 12, the second interface pad 32 is electrically connected to the top pin of the local interconnection component 2, and the fifth interface pad 37 is electrically connected to a top pin of the passive device 6. A third interface pad 33 and a fourth interface pad 34 that are configured to connect to the PCB are formed on the second build-up layer. The third interface pad 33 is electrically connected to the first through via 12, and the fourth interface pad 34 is electrically connected to the second through via 13. As interfaces connected to dies 30 and the PCB 20, the interface pads can be directly configured to implement corresponding electrical connection. Alternatively, external connection bumps may be stacked on the interface pads, to implement connection to the dies 30 and the PCB 20 through corresponding external connection bumps.

As shown in FIG. 2, the build-up layers 3 on the two sides of the interconnection interposer component 10 each are covered with a solder mask layer (green oil layer) 4, and external connection bumps 5 are formed on the solder mask layer 4. On a side on which the local interconnection component 2 of the interconnection interposer component 10 is located, the external connection bumps 5 may include a first external connection bump 51 and a second external connection bump 52. The first external connection bump 51 is connected to the first through via 12 through the first interface pad 31 and a blind via 36 in the build-up layer in sequence, and each second external connection bump 52 is connected to a top pin of a corresponding local interconnection component 2 through the second interface pad 32 and a stacked via 35 in the build-up layer in sequence. On the other side of the interconnection interposer component 10, the external connection bumps 5 may include a third external connection bump 53 and a fourth external connection bump 54. The third external connection bump 53 is connected to the first through via 12 through the third interface pad 33 and a corresponding blind via 36 in sequence, and the fourth external connection bump 54 is connected to the second through via 13 through the fourth interface pad 34 and a corresponding blind via 36 in sequence.

For the passive device 6 embedded in the second slot 14, on the side on which the local interconnection component 2 of the interconnection interposer component 10 is located, the external connection bumps 5 may further include a fifth external connection bump 44. The fifth external connection bump 44 is connected to the pin of the passive device 6 through the fifth interface pad 37 and a corresponding blind via 36 in sequence.

During specific implementation, the external connection bumps 5 may be implemented by using a same process, or may be implemented by using different processes as required. For example, the first external connection bump 51, the third external connection bump 53, the fourth external connection bump 54, and the fifth external connection bump 55 may be external bump structures formed based on a small outline package (Small Outline Package, SOP) process, but this is not limited thereto. The second external connection bump 52 may be of a nickel/tin pillar structure, so that a high-density bump layout can be formed in correspondence to the high-density interconnection line layer on a local interconnection component-2 side, and reliable electrical connection and good heat dissipation performance can be provided.

In another possible implementation, a quantity of disposed external connection bumps 5 and molding processes of the external connection bumps 5 may be determined based on an overall product design. This is not limited in embodiments of this application. In correspondence to each local interconnection component 2, a quantity of disposed second external connection bumps 52 may be determined based on a top pin layout of the local interconnection component 2. As shown in FIG. 2, each local interconnection component 2 is interconnected with two adjacent dies 30. In another possible implementation, each local interconnection component 2 may be interconnected with more than two dies 30. In other words, a plurality of dies 30 may be electrically connected through one local interconnection component 2.

Based on a structural feature that the local interconnection component 2 is embedded in the carrier layer 1, determining of a thickness of the build-up layer 3 only needs to meet a forming condition of the second interface pad 32 corresponding to the local interconnection component 2. In this way, corresponding electrical connection can be implemented by properly controlling the thickness of the build-up layer 3 and disposing a layer of stacked through via in the build-up layer 3, which offers better processability.

In a possible implementation solution, structural forms and board surface layout forms of the first interface pad 31 and the second interface pad 32 may be determined based on external interface forms of the local interconnection component 2 and the dies. Similarly, structural forms and board surface layout forms of the third interface pad 33 and the fourth interface pad 34 may be further determined based on an interface form on the PCB side. This is not limited in embodiments of this application.

For the local interconnection component 2, the dielectric layer of the local interconnection component 2 may be made of an organic material. During specific implementation, the dielectric layer of the local interconnection component 2 may be made of PI, PP, or an ABF.

For the PCB 20, a substrate of the PCB 20 may be a BT (Bismaleimide Triazine, BT resin) board. Certainly, in another possible implementation solution, the PCB 20 may be a circuit board in an inorganic system, and the substrate of the PCB 20 may be a ceramic board, a glass board, a metal board, or the like. This is not limited in embodiments of this application.

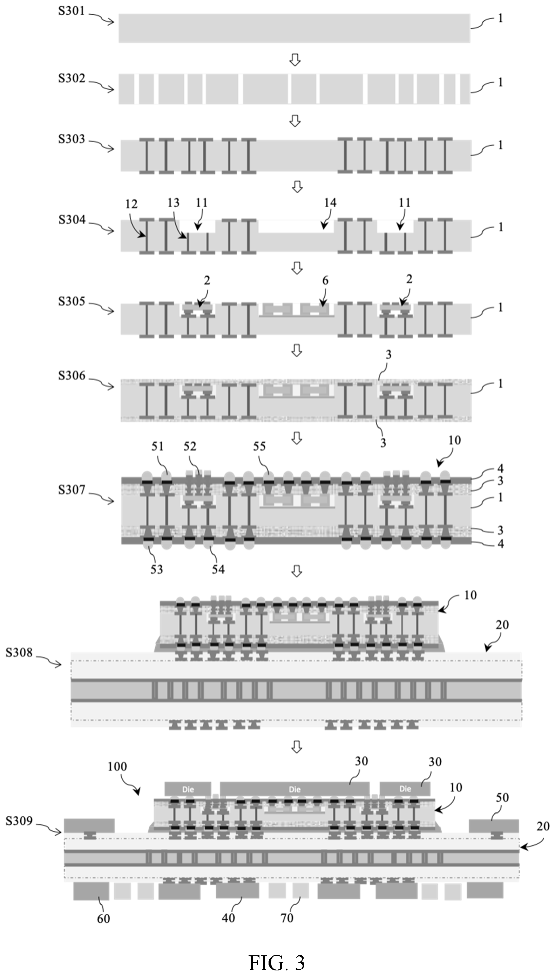

With reference to FIG. 3, the following briefly describes an assembly procedure of the chip-on-board system shown in FIG. 1.

Step S301: Prepare an incoming glass base material of a carrier layer 1.

Step S302: Provide TGV vias. The TGV vias are provided at positions of formed through vias (a first through via 12 and a second through via 13) of the glass base material. A specific via forming process may be determined according to an overall product design requirement, which is, for example but not limited to, a sandblasting method, a photosensitive glass method, or a laser-induced etching method.

Step S303: Perform metal patterning on the TGVs. Based on a TGV process, electroplating and via filling are performed, and corresponding interface pads are formed on surfaces on two sides of the carrier layer 1. For example, a copper paste via plugging process, a double-sided copper paste printing process, and a sintering process are used to manufacture a through-current structure with good heat transfer and through-current capabilities. However, this is not limited thereto.

Step S304: Provide blind slots and perform local polishing. A first slot 11 and a second slot 14 are provided on the carrier layer 1. During specific implementation, the slot may be provided by using a UV laser (ultraviolet laser), a CO₂ laser (carbon dioxide laser), or another mechanical processing process, and local polishing is performed to form an embedded accommodation cavity.

Step S305: Embed a local interconnection component 2 and a passive device 6. Herein, a bottom pin of the local interconnection component 2 is connected to the second through via 13 at a slot bottom of the first slot 11. During specific implementation, the passive device 6 may be a capacitor or an inductor.

Step S306: Fill the blind slots and perform lamination for layer build-up. Lamination is performed to fill a gap between the local interconnection component 2 and the first slot 11 and a gap between the passive device 6 and the second slot 14, and the two sides of the carrier layer 1 are hot-pressed and leveled to form build-up layers 3. During specific implementation, a filling material and a build-up layer material may be ABFs.

In another possible implementation, a material used to fill the gap may be the same as or different from the build-up layer material.

Step S307: Perform patterned via filling and form external connection bumps (bumps), to manufacture an interconnection interposer component 10.

First, a blind via is provided and a pad structure is formed on the build-up layer 3. For example, a pad surface may be processed by using an ENIG (Electroless Nickel/Immersion Gold, electroless nickel/immersion gold) process. However, this is not limited thereto and may be specifically selected based on an actual process condition. This is not limited in embodiments of this application.

In addition, outer solder mask layers 4 are formed on exteriors of the build-up layers 3 on the two sides, and surfaces of outer metal are processed to form interface pads. Second external connection bumps 52 connected to a top pin of the local interconnection component 2 may be Ni/Sn pillars at a pitch (Pitch) of 50 um, providing both good electrical connection and heat dissipation performance. First external connection bumps 51, third external connection bumps 53, fourth external connection bumps 54, and fifth external connection bumps 55 on two sides of the interconnection interposer component 10 may be external bump structures, at a pitch (Pitch) of 130 um to 150 um, formed based on a small outline package process with good processability.

During specific implementation, processes of providing the vias, electroplating, and surface pads may be implemented by using a conventional technology. This is not limited in embodiments of this application.

Based on the interconnection interposer component 10 obtained in step 301 to step 307, the interconnection interposer component 10 may be first assembled on a PCB 20, and then device assembly is performed.

Step S308: Perform PCB assembly and underfill (underfill). The interconnection interposer component 10 is placed on the PCB 20, and the third external connection bump 53 and the fourth external connection bump 54 on the interconnection interposer component 10 are soldered with interface pads on a surface layer of the PCB 20, to meet a system requirement. In addition, an underfill process may be used to protect a solder joint between the interconnection interposer component 10 and the PCB 20. Specifically, a liquid underfill material is injected or dispensed around a periphery of the interconnection interposer component 10, penetrates between the interconnection interposer component 10 and the PCB 20 based on a capillary flow principle, and is heated and cured, to effectively improve soldering reliability.

In another possible implementation solution, the liquid underfill may alternatively be replaced with an NCF (Non-Conductive Adhesive Film, non-conductive adhesive film), so that a function of reliably fastening the interconnection interposer component 10 can also be implemented.

Step S309: Perform device assembly, to manufacture the chip-on-board system 100 that implements vertical power supply. During specific implementation, according to a function configuration requirement of the system, dies 30 may be optionally connected to the first external connection bump 51 and the second external connection bump 52 on the top of the interconnection interposer component 10, to implement electrical connection to the PCB 20 through the interconnection interposer component 10.

A connector 50 and the interconnection interposer component 10 are located on a board surface on a same side of the PCB 20. A power supply assembly 40, a super voltage divider module 60, and a multi-layer ceramic capacitor 70 are located on a board surface on the other side of the PCB 20.

In another possible implementation, based on the interconnection interposer component 10 obtained in step 301 to step 307, the dies may be first assembled on the interconnection interposer component 10, then the interconnection interposer component 10 integrated with the dies is assembled on the PCB 20, and finally assembly of other devices on the board is completed. This is not limited in embodiments of this application.

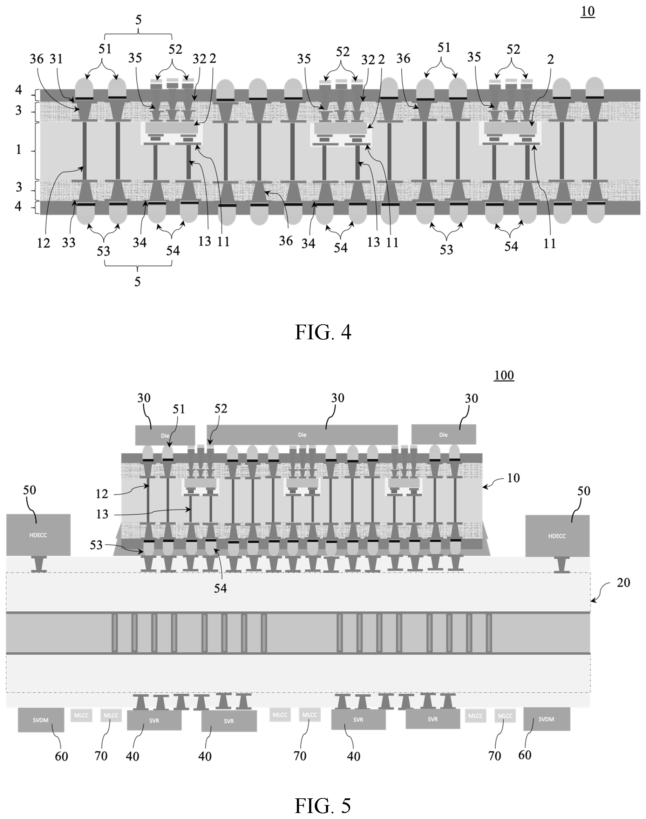

In the interconnection interposer component described in the foregoing embodiment, a passive device is embedded in the carrier layer of the interconnection interposer component, to improve electrical performance. During other specific implementation, the carrier layer of the interconnection interposer component may alternatively be embedded with only the local interconnection component 2 configured for assembly of the dies on the board. Refer to FIG. 4 and FIG. 5. FIG. 4 is a diagram of another interconnection interposer component according to an embodiment of this application. FIG. 5 is a diagram of an architecture of another chip-on-board system according to an embodiment of this application. The architecture of the system is constructed and formed based on the interconnection interposer component shown in FIG. 4. To clearly show differences and relationships between this implementation solution and the embodiments described in FIG. 1 and FIG. 2, compositions and structures of a same function are illustrated by using a same mark in the figure.

This implementation solution is different from the interconnection interposer component described in FIG. 2 in that the interconnection interposer component 10 is only embedded with the local interconnection component 2. As shown in FIG. 4, on the first surface of the carrier layer 1, a plurality of first slots 11 for embedding local interconnection components 2 are provided. With reference to FIG. 5, based on a plurality of local interconnection components 2 embedded in the carrier layer 1, short-distance interconnection between dies 30 is implemented by fully using a panel size of the carrier layer 1.

It should be noted that a quantity of disposed local interconnection components 2 in the carrier layer 1 may be determined based on an overall product design. This is not limited in embodiments of this application.

In addition to the foregoing chip packaging system, this implementation further provides an electronic device. FIG. 5 is a diagram of a structure of an electronic device according to an embodiment of this application.

As shown in FIG. 5, the electronic device 1000 includes a housing 300 and a mainboard 200 disposed in the housing 300. The mainboard 200 is provided with the chip-on-board system 100 described in the foregoing embodiment. Herein, the chip-on-board system 100 may be a functional component such as a CPU, a GPU, an ASIC, or a SOC.

During specific implementation, the electronic device may be a server, a computer, or a high-performance compute cluster, for example, a data center server with high power, high integration, and an ultra-large scale. In addition, the electronic device may alternatively be a switch, a router, a building baseband unit, an edge device, or the like. This is not limited in embodiments of this application.

It should be understood that other functions of the electronic device are not core inventive points of this application, and may be implemented by a person skilled in the art using the conventional technologies. Therefore, details are not described in this specification.

The foregoing descriptions are merely example implementations of the present invention. It should be noted that a person of ordinary skill in the art may make several improvements or polishing without departing from the principle of the present invention and the improvements or polishing shall fall within the protection scope of the present invention.

## Claims

1. An interconnection interposer component, comprising a local interconnection component and a carrier layer, wherein the carrier layer comprises a first surface and a second surface, the first surface of the carrier layer is provided with a first slot, and the local interconnection component is embedded in the first slot;
the carrier layer is provided with a first through via and a second through via, the first through via runs through the first surface and the second surface of the carrier layer, and the second through via runs through a slot bottom of the first slot and the second surface of the carrier layer;
a build-up layer on a first surface side of the carrier layer is provided with a first interface and a second interface that are configured to connect to dies, and a build-up layer on a second surface side of the carrier layer is provided with a third interface and a fourth interface that are configured to connect to a printed circuit board; and
the first interface is electrically connected to the third interface through the first through via, the second interface is electrically connected to the fourth interface through the local interconnection component and the second through via, and the local interconnection component is electrically connected to a plurality of second interfaces.

2. The interconnection interposer component according to claim 1, wherein the carrier layer is made of a rigid inorganic material.

3. The interconnection interposer component according to claim 2, wherein the rigid inorganic material is a glass material.

4. The interconnection interposer component according to claim 3, wherein the first through via and the second through via in the carrier layer are through glass vias.

5. The interconnection interposer component according to any one of claims 1 to 4, wherein the build-up layer is made of an organic material.

6. The interconnection interposer component according to claim 5, wherein the build-up layer is made of an Ajinomoto build-up film.

7. The interconnection interposer component according to any one of claims 1 to 6, wherein the first interface, the second interface, the third interface, and the fourth interface are respectively interface pads formed on the build-up layers on the sides on which the first interface, the second interface, the third interface, and the fourth interface are located.

8. The interconnection interposer component according to claim 7, wherein the build-up layers on the two sides of the carrier layer each are covered with a solder mask layer; a first external connection bump and a second external connection bump are formed on a solder mask layer on one side of the carrier layer, and the first external connection bump and the second external connection bump are respectively electrically connected to the first interface and the second interface on the side on which the first external connection bump and the second external connection bump are located; and a third external connection bump and a fourth external connection bump are formed on a solder mask layer located on the other side of the carrier layer, and the third external connection bump and the fourth external connection bump are respectively electrically connected to the third interface and the fourth interface on the side on which the third external connection bump and the fourth external connection bump are located.

9. The interconnection interposer component according to claim 8, wherein the second external connection bump is of a nickel/tin pillar structure.

10. The interconnection interposer component according to claim 8 or 9, further comprising a passive device, wherein the first surface of the carrier layer is further provided with a second slot, and the passive device is embedded in the second slot; and
the build-up layer on the first surface side of the carrier layer is further provided with a fifth interface configured to connect to a die, and the fifth interface is electrically connected to the passive device.

11. The interconnection interposer component according to claim 10, wherein a fifth external connection bump is further formed on the solder mask layer located on the one side of the carrier layer, and the fifth external connection bump is electrically connected to the fifth interface.

12. The interconnection interposer component according to claim 11, wherein the first external connection bump, the third external connection bump, the fourth external connection bump, and the fifth external connection bump are all external bump structures formed by using a small outline package process.

13. The interconnection interposer component according to any one of claims 1 to 12, wherein the local interconnection component comprises a dielectric layer and a high-density interconnection line layer that are stacked, and the dielectric layer is made of an organic material.

14. A chip packaging system, wherein the chip packaging system comprises a printed circuit board, a plurality of dies, and the interconnection interposer component according to any one of claims 1 to 13, the interconnection interposer component is disposed on a board surface of the printed circuit board and is connected to the printed circuit board through the third interface and the fourth interface, at least two dies are coupled to the printed circuit board through the interconnection interposer component and are connected to the interconnection interposer component through the first interface and the second interface, and two adjacent dies are electrically connected through the local interconnection component on the interconnection interposer component.

15. The chip packaging system according to claim 14, wherein at least one die is electrically connected to the passive device on the interconnection interposer component through the fifth interface.

16. The chip packaging system according to claim 14 or 15, wherein a solder joint between the interconnection interposer component and the printed circuit board is covered with underfill.

17. The chip packaging system according to any one of claims 14 to 16, wherein a plurality of interconnection interposer components are disposed, and the plurality of interconnection interposer components are spaced apart on the board surface of the printed circuit board.

18. The chip packaging system according to any one of claims 14 to 17, wherein a substrate of the printed circuit board is a resin board, a ceramic board, a glass board, or a metal board.

19. The chip packaging system according to any one of claims 14 to 18, wherein the chip packaging system further comprises another functional device disposed on the printed circuit board.

20. The chip packaging system according to claim 19, wherein the another functional device comprises at least one of a power supply assembly, a connector, and a capacitor.

21. The chip packaging system according to claim 19 or 20, wherein the another functional device and the interconnection interposer component are located on the board surface on a same side of the printed circuit board, or the another functional device is located on a board surface of the printed circuit board on a side opposite to the interconnection interposer component.

22. An electronic device, comprising a mainboard and the chip packaging system according to any one of claims 14 to 21, wherein the chip packaging system is disposed on the mainboard.
